# EUROPÄISCHE PATENTSCHRIFT

(11) **EP 2 024 271 B1**
(45) Veröffentlichungstag und Bekanntmachung des Hinweises auf die Patenterteilung: **18.09.2013**
(21) Anmeldenummer: 06753265.5
(22) Anmeldetag: 03.06.2006
(51) Int. Cl.: B81B 3/00, G02B 26/08

(54) **ANORDNUNG VON ELEKTRODEN ZU BEWEGLICHEN MIKROMECHANISCHEN ELEMENTEN**
ARRANGEMENT OF ELECTRODES WITH RESPECT TO MOVING MICROMECHANICAL ELEMENTS
Disposition d'électrodes par rapport à des éléments micromécaniques mobiles

(43) Veröffentlichungstag der Anmeldung: 18.02.2009
(73) Patentinhaber: Fraunhofer-Gesellschaft zur Förderung der angewandten Forschung e.V., 80686 München (DE)
(72) Erfinder: WULLINGER, Ingo, 01099 Dresden (DE); DÜRR, Peter, 01099 Dresden (DE)
(74) Vertreter: Pfenning, Meinig & Partner GbR
(86) Internationale Anmeldenummer: PCT/DE2006/000997
(87) Internationale Veröffentlichungsnummer: WO 2007/140731

(56) Entgegenhaltungen:
- US-A1- 3 886 310
- US-A1- 2005 174 628

## Beschreibung

Die Erfindung betrifft Anordnungen von mikromechanischen, bevorzugt mikrooptischen Elementen, die jeweils mittels Federelementen gehalten sind. Sie können dabei durch die Wirkung elektrostatischer Kräfte um eine Rotationsachse verschwenkt oder auch translatorisch ausgelenkt werden. Elektromagnetische Strahlung kann auf ein Fläche solcher mikrooptischen Elemente auftreffen und von dort reflektiert werden, wobei die Reflexion unter Berücksichtigung der jeweiligen Schwenkwinkel mikrooptischer Elemente erfolgen kann, um eine Projektion von Bildern zu erreichen oder Muster für die Herstellung von Halbleiterstrukturen auszubilden.

Für die Auslenkung mikromechanischer Elemente sind Elektroden unterhalb der mikromechanischen Elemente angeordnet, an die für eine Verschwenkung oder translatorischen Auslenkung eine vorgebbare elektrische Spannung angelegt werden kann. Die Auslenkung erfolgt dabei entsprechend der jeweiligen elektrostatischen Kraft und der Rückstellkraft der Federelemente. Bei ausgelenkten mikromechanischen Elementen werden diese bei keiner oder reduzierter elektrostatischer Kraft wieder in ihre Ausgangsstellung zurück verschwenkt bzw. ausgelenkt. In diesen Fällen ist also die Rückstellkraft der jeweiligen Federelemente größer als die elektrostatische Kraft.

Je nach elektrischer Spannung kann eine elektrostatische Kraft aufgebracht werden, die ausreicht ein mikromechanisches Element um einen bestimmten Winkel zu verschwenken oder Weg auszulenken, was z.B. für eine gezielte Reflexion auftreffender elektromagnetischer Strahlung genutzt werden kann. Die Verschwenkung um die Rotationsachse oder translatorische kann auch in zwei jeweils entgegen gesetzte Richtungen erfolgen. Durch entsprechende Verschwenkung mehrerer mikrooptischer Elemente einer Anordnung können die verschiedensten Abbildungen projiziert oder Muster ausgebildet werden.

Die jeweilige Auslenkung mit dem gewünschten Schwenkwinkel oder Weg hängt vom Verhältnis der Rückstellkraft der Federelemente und der elektrostatischen Kraft und letztere im Wesentlichen von der elektrischen Spannungsdifferenz zwischen dem jeweiligen mikromechanischen Element und einer diesem zugeordneten Elektrode ab. Hier ist eine präzise Steuerung erwünscht, um den gewünschten Verschwenkwinkel einhalten zu können.

Üblicherweise ist eine Vielzahl solcher mikromechanischer Elemente in Form einer Array-Anordnung im Einsatz, wobei die Dimensionierung der mikromechanischen Elemente möglichst klein gehalten werden sollte. So können mehr als eine Million solcher mikromechanischen Element an einem Chip vorhanden sein. Sie können mit einem oder mehreren CMOS-Schaltkreis(en) gesteuert werden, der/die unterhalb mikromechanischer Elemente angeordnet ist/sind und die mikromechanischen Elemente.mit den ihnen zugeordneten Elektroden jeweils einzeln ansteuern.

Eine solche Lösung ist aus US 5,142,405 bekannt. Dabei sind jedem hier mikrooptischen Element, die elektromagnetische Strahlung an einer Fläche reflektieren, jeweils zwei Elektroden zugeordnet, die unterhalb der mikrooptischen Elemente angeordnet sind, vorhanden. Die mikrooptischen Elemente sind an zwei sich gegenüberliegenden Seiten mit Torsionsfederelementen gehalten, die in der Rotationsachse ausgerichtet sind, um die eine Verschwenkung erreicht werden soll und kann. Zwischen mikrooptischen Elementen sind Spalte vorhanden, durch die elektromagnetische Strahlung bis auf ein Substrat, auf dem Elektroden ausgebildet sind, einfallen kann.

Die einzelnen mikrooptischen Elemente können dann, wie bereits angesprochen individuell durch Steuerung der elektrischen Spannung an Elektroden, um bestimmte Winkel in der jeweiligen Richtung verschwenkt werden. Dabei werden elektrische Spannungen z.B. im Bereich 0 bis ca. 10 V eingesetzt. So kann an einer Elektrode, die an einer Seite unterhalb eines mikrooptischen Elements angeordnet ist, eine elektrische Spannung anliegen. Die jeweils andere Elektrode und das mikrooptische Element können spannungsfrei geschaltet sein und dabei auf Erdpotential liegen. Es besteht aber auch die Möglichkeit mittels einer elektrischen Stromzuführung zum mikrooptischen Element diesem eine elektrische Spannung zuzuführen, so dass eine elektrostatische Kraftwirkung für eine Verschwenkung des mikrooptischen Elementes entsprechend der jeweiligen Differenz der elektrischen Spannungen zwischen Elektrode und mikrooptischen Element ausgenutzt werden kann, die zum gewünschten Verschwenkwinkel führt Beim Stand der Technik werden generell Elektroden eingesetzt, die einem einzigen mikrooptischen Element zu dessen Auslenkung zugeordnet sind.

Wie bereits angedeutet kann elektromagnetische Strahlung durch Spalte zwischen mikromechanischen Elementen oder auch einem Rahmen und mikromechanischen Elementen einfallen. Diese Strahlung kann auf das elektrisch isolierende Substrat auftreffen und zu eine elektrischen Aufladung führen. Die elektrische Aufladung erhöht sich in Folge kumulativer Effekte über die Zeit und stört das Verhältnis der wirkenden Kräfte. Die elektrische Aufladung erfolgt dabei in Bereichen am Substrat, die am weitesten von der Rotationsachse entfernt sind, um die eine verschwenkende Auslenkung erfolgen kann, so dass die dadurch zu verzeichnende Kraftwirkung durch den Abstand zur Rotationsachse bzw. dem Masseschwerpunkt ein erhöhtes Drehmoment bewirkt und so das gewünschte Kräfteverhältnis von Feder- und elektrostatischer Kraftwirkung erheblich beeinflusst wird. Es treten dadurch Driften der Auslenkung über die Zeit auf, die aufwändig durch Kalibrierung kompensiert oder in Kauf genommen werden müssen.

Die durch Spalte einfallende elektromagnetische Strahlung kann auch Fotoströme induzieren, die auch tiefere Schichten eines CMOS-Aufbaus beeinflussen und dabei zu Ladungsverlusten eines Speicherkondensators führen können. Dies stört wieder die elektrische Ansteuerung von Elektroden und/oder mikromechanischen Elementen, was zu unerwünschten Veränderungen der jeweiligen Auslenkung mikromechanischer Elemente von Vorgaben führen kann.

Eine Abschirmung, mit der ein Auftreffen elektromagnetischer Strahlung in kritischen Bereichen verhindert werden kann, ist aber kontraproduktiv, da dadurch der nutzbare Winkelbereich für eine Verschwenkung mikromechanischer Elemente reduziert werden würde.

Weiterhin ist aus US 3,886,310 ein elektrostatisch auslenkbares Lichtventil bekannt, bei dem mehrere auslenkbare reflektierende Elemente vorhanden sind und ein Array bilden. Dabei ist ein elektrisch leitendes Gitter für die Auslenkung auf einem Substrat unterhalb der Elemente angeordnet.

Ausgehend hiervon, ist es Aufgabe der Erfindung eine Anordnung mit mikromechanischen Elementen zur Verfügung zu stellen, die über einen großen Zeitraum driftfrei betrieben werden kann, ohne dass häufiges Nachkalibrieren erforderlich ist.

Erfindungsgemäß wird diese Aufgabe mit einer Anordnung, die die Merkmale des Anspruchs 1 aufweist, gelöst. Vorteilhafte Ausgestaltungen und Weiterbildungen der Erfindung können mit in untergeordneten Ansprüchen bezeichneten Merkmalen erreicht werden.

Die erfindungsgemäße Anordnung mit mikromechanischen Elementen, die durch die Wirkung elektrostatischer Kräfte um eine Rotationsachse verschwenkt oder auch translatorisch ausgelenkt werden können, ist dabei so ausgebildet, dass unterhalb mikromechanischer Elemente, also auf der Seite, auf die keine elektromagnetische Strahlung unmittelbar auftreffen kann, ebenfalls Elektroden angeordnet sind. Dabei ist jeweils eine Elektrode so angeordnet und ausgebildet, dass sie mindestens zwei mikromechanischen Elementen zugeordnet ist. Sie kann dabei eine Auslenkung der ihnen zugeordneten mikromechanischen Elemente durch elektrostatische Kraftwirkung bewirken. Hierzu ist es lediglich erforderlich eine geeignete Differenz der elektrischen Spannung zwischen der Elektrode und dem jeweiligen mikromechanischen Element einzustellen.

Hierzu sind Elektroden im Bereich von Spalten benachbarter mikromechanischer Elemente angeordnet. Die Fläche und geometrische Gestaltung von Elektroden sollte möglichst so gewählt sein, dass mindestens.50 %, bevorzugt mindestens 70 % der elektromagnetischen Strahlung, die unter Berücksichtigung der jeweiligen Spaltmaße und der Apertur durch Spalte einfallen kann, auf die Oberfläche von Elektroden auftrifft. Dabei sollte der Spaltbereich zwischen benachbart angeordneten mikromechanischen Elementen überlappt sein, was durch eine laterale Ausdehnung von Elektroden senkrecht zur Ausrichtung eines Spaltes erreicht werden kann, die Spaltbreite und den Abstand Elektrode zu mikromechanischen Elementen berücksichtigt.

Für die Ansteuerung sollen nicht nur Elektroden einer erfindungsgemäßen Anordnung sondern auch mikromechanische Elemente an eine elektrische Spannungsquelle angeschlossen und auch für eine gezielte Auslenkung mikromechanischer Elemente einzeln ansteuerbar sein. So kann durch definierte Einstellung der elektrischen Spannung am mikromechanischen Element, dieses gezielt ausgelenkt werden, auch wenn die elektrische Spannung an den ihm zugeordneten Elektroden konstant gehalten ist.

Nachfolgend soll als bevorzugte Ausführung für mikromechanische Elemente auf mikrooptische Elemente Bezug genommen werden, wobei die Ausführungen natürlich auch auf andere rotatorisch oder translatorisch auslenkbare Elemente zutreffen können.

Vorteilhaft können die jeweiligen Elektroden am radial äußeren Randbereich mikrooptischer Elemente anzuordnen, nämlich dort wo die jeweils größte Winkelauslenkung beim Verschwenken auftritt, da so die erforderliche elektrische Spannung kleiner gehalten werden kann, um die für eine Auslenkung erforderlichen Kräfte elektrostatisch aufbringen zu können.

Dabei können die jeweiligen Elektroden auch die Gestalt äußerer Randbereiche und/oder die Ausrichtung von Rotationsachsen ihnen zugeordneter mikrooptischer Elemente berücksichtigen. So können Elektroden bogenförmige äußere Randkonturen aufweisen, wenn beispielsweise äußere Ränder mikrooptischer Elemente konkav bzw. konvex gewölbt ausgebildet sind.

Sie können aber auch an abgewinkelte eckige äußere Ränder von mikrooptischen Elementen in ihrer geometrischen Gestaltung und Dimensionierung angepasst sein.

Bei der Erfindung kann jeweils eine Elektrode gemeinsam zwei mikrooptischen Elementen, deren Rotationsachsen parallel zueinander ausgerichtet sind, zugeordnet sein.

Es ist aber auch möglich, jeweils eine Elektrode gemeinsam zwei mikrooptischen Elementen, deren Rotationsachsen nicht parallel zueinander ausgerichtet sind, zuzuordnen. Die Rotationsachsen können dabei senkrecht zueinander oder auch in einem Winkel zwischen 0 und 90° ausgerichtet sein.

Es kann aber auch eine Elektrode so ausgebildet und angeordnet sein, dass mit ihr eine Auslenkung von mindestens drei mikrooptischen Elementen ermöglicht ist. Dabei können die mikrooptischen Elemente um Rotationsachsen verschwenkt werden, die nicht parallel zueinander ausgerichtet sind. Es können aber auch mittels einer Elektrode mindestens drei mikrooptische Elemente ausgelenkt werden, von denen mindestens zwei mikrooptische Elemente parallel zueinander ausgerichtete Rotationsachsen aufweisen.

Mit der Erfindung kann verhindert werden, dass zumindest ein größerer Teil oder keine einfallende elektromagnetische Strahlung auf das Substrat auftrifft und so eine elektrische Aufladung reduziert oder ganz verhindert werden kann.

Ladungsträger können zwischen den bevorzugt auch größer als beim Stand der Technik ausgebildeten Elektroden und Trägern mikrooptischer Elemente, die nah an der Rotationsachse angeordnet sind, weiterhin auftreten.

So kann die Langzeitstabilität für eine gezielte Auslenkung mikrooptischer Elemente an einer erfindungsgemäßen Anordnung verbessert oder erreicht werden.

Durch die Ausnutzung größerer Flächenbereiche mit Elektroden kann die elektrostatische Kraftwirkung erhöht werden. Die erforderliche Kraft für eine Auslenkung eines mikrooptischen Elementes kann mit kleinerer elektrischer Spannung erreicht werden.

Es gibt keine elektrischen Felder zwischen nebeneinander angeordneten Elektroden, wie sie beim Stand der Technik eingesetzt worden sind, die die elektrostatische Kraftwirkung auf die mikrooptischen Elemente reduzieren würden.

Es besteht aber auch die Möglichkeit, dass Torsionsfederelemente mit höherer Steifigkeit, also solche mit höherer Federkonstante, eingesetzt werden. Dies ist durch die auf mikrooptische Elemente wirkenden höheren Kräfte, die bei vergleichbaren elektrischen Parametern erzielt werden können, möglich.

Steifere Torsionsfederelemente weisen bessere mechanische Eigenschaften auf und es kann dadurch einer Verformung oder einem Verzug mikrooptischer Elemente entgegen gewirkt werden. Außerdem kann ohne solche Effekte auch mit höheren elektrischen Spannungen gearbeitet werden.

Bei vorgegebener elektrischer Spannung ist der Abstand eines Isolators zwischen Elektroden benachbarter mikrooptischer Elemente üblicherweise konstant und kann nicht weiter reduziert werden, um die mikrooptischen Elemente weiter zu miniaturisieren. Der relative Verlust an nutzbarer Fläche steigt bei kleineren mikrooptischen Elementen an. Mit der Erfindung fallen diese nicht nutzbaren Flächen aber weg bzw. sie sind deutlich kleiner, so dass die erreichbaren Kräfte für die Auslenkung mikrooptischer Elemente größer sind.

Durch die bei gleichen elektrischen Parametern erreichbaren höheren Kräfte kann auch die Dimensionierung mikrooptischer Elemente verringert werden, so dass mikrooptische Elemente mit kleineren optisch wirksamen Flächen genutzt werden können, da kleinere mikrooptische Elemente für eine analoge Auslenkung größere elektrostatische Kräfte erfordern.

Auch die beim Stand der Technik auftretende nachteilige Beeinflussung von CMOS-Schaltungselementen, kann durch die Vermeidung von Ladungseffekten, vermieden werden.

All dies führt zu einer deutlichen Verbesserung der Langzeitstabilität erfindungsgemäßer Anordnungen.

Nachfolgend soll die Erfindung beispielhaft näher erläutert werden.

Dabei zeigt:

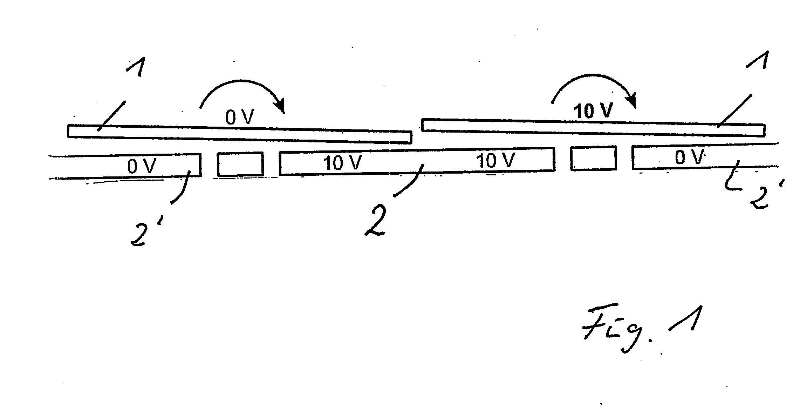

Figur 1 in schematischer Form zwei mikrooptische Elemente, die an einer erfindungsgemäßen Anordnung eingesetzt werden können.

In Figur 1 sind zwei plattenförmige mikrooptische Elemente 1 gezeigt. Sie sind um eine senkrecht in die Zeichnungsebene weisende Rotationsachse um vorgebbare Winkelbeträge verschwenkbar und mit nicht dargestellten Torsionsfederlementen, die in der Rotationsachse liegen, gehalten.

Außerdem sind mehrere Elektroden 2, 2' unterhalb der mikrooptischen Elemente 1 angeordnet. Dabei ist jeweils eine Elektrode 2 den beiden benachbarten mikrooptischen Elementen 1 zugeordnet und so angeordnet und ausgebildet, dass der Spalt 3 zwischen den benachbarten mikrooptischen Elementen 1 durch die jeweilige Elektrode 2 überdeckt ist. So kann durch den Spalt 3 keine elektromagnetische Strahlung mit Photonen auf ein hier nicht dargestelltes elektrisch isolierendes Substrat auftreffen.

Über ebenfalls nicht dargestellte zusätzliche Kontakte oder weitere Elektroden kann eine Zuführung für elektrischen Strom zu den einzelnen mikrooptischen Elementen 1 realisiert sein.

So ist das in Figur 1 rechts dargestellte mikrooptische Element 1 auf eine elektrische Spannung von hier beispielsweise 10 V gelegt, wohingegen das links dargestellte mikrooptische Element 1 spannungsfrei, also auf 0 V gelegt ist.

Die Elektrode 2, die zwischen den beiden mikrooptischen Elementen 1 angeordnet ist, ist an eine elektrische Spannung von 10 V angeschlossen. Die beiden außen im Anschnitt dargestellten Elektroden 2' sind z.B auf Erdpotential mit ebenfalls 0 V gelegt.

So können, wie in Figur 1 gezeigt, die beiden mikrooptischen Elemente 1 in die gleiche Richtung verschwenkt werden.

Mit anderen elektrischen Spannungsverhältnissen zwischen den mikrooptischen Elementen 1 und Elektroden 2 und 2' können aber auch unterschiedliche Winkelauslenkungen von mikrooptischen Elementen 1 oder auch andere Auslenkungsrichtungen realisiert werden.

Mit den hier außen angeordneten Elektroden 2' können weitere hier nicht dargestellte mikrooptische Elemente beeinflusst werden, denen diese Elektroden 2' ebenfalls zugeordnet sind.

## Patentansprüche

1. Anordnung von mikromechanischen Elementen und Elektroden die für eine elektrostatische Auslenkung der mikromechanischen Elemente (1) unterhalb dieser angeordnet sind, wobei
- die mikromechanischen Elemente (1) jeweils mittels Federelementen gehalten und durch elektrostatische Kraftwirkung um mindestens eine Rotationsachse verschwenkbar oder translatorisch auslenkbar sind;
- zwei benachbart zueinander angeordnete mikromechanische Elemente (1) durch eine Spalte getrennt sind,
- im Bereich der Spalten zwischen benachbarten mikromechanischen Elementen (1) jeweils eine Elektrode (2, 2') für eine elektrostatische Auslenkung von mindestens zwei benachbart zueinander angeordneten mikromechanischen Elementen (1) vorhanden ist;
**dadurch gekennzeichnet dass** die mikromechanische Elemente (1) an eine elektrische Spannungsquelle angeschlossen sind, und Elektroden (2, 2') und/oder mikromechanische Elemente (1) für eine elektrostatische Auslenkung jeweils einzeln elektrisch ansteuerbar sind.

2. Anordnung nach Anspruch 1, **dadurch gekennzeichnet, dass** die Fläche und geometrische Gestaltung der Elektrode (n) (2, 2') unter Berücksichtigung der von Spaltmaßen benachbarter mikromechanischer Elemente (1) und der Apertur durch Spalte (3) einfallender elektromagnetischer Strahlung so gewählt sind, dass mindestens 50 % der einfallenden elektromagnetischen Strahlung auf die Oberfläche von Elektroden auftreffen.

3. Anordnung nach Anspruch 1 oder 2, **dadurch gekennzeichnet, dass** die jeweils eine Elektrode (2, 2') unterhalb eines Spaltbereiches zwischen benachbart angeordneten mikromechanischen Elementen (1), den Spaltbereich überlappend ausgebildet sind.

4. Anordnung nach einem der vorhergehenden Ansprüche, **dadurch gekennzeichnet, dass** Elektroden (2, 2') am radial äußeren Randbereich mikromechanischer Elemente (1), an dem die jeweils größte Winkelauslenkung auftritt, ausgebildet sind.

5. Anordnung nach einem der vorhergehenden Ansprüche, **dadurch gekennzeichnet, dass** eine Oberfläche zumindest bereichsweise für auf die Oberfläche auftreffende elektromagnetische Strahlung optisch wirksam ist.

6. Anordnung nach Anspruch 5, **dadurch gekennzeichnet, dass** die Oberfläche elektromagnetische Strahlung reflektiert.

7. Anordnung nach einem der Ansprüche 5 oder 6, **dadurch gekennzeichnet, dass** eine oder mehrere der Elektrode(n) (2, 2') auf der Seite, die der Seite mit optisch wirksamer Oberfläche gegenüberliegt angeordnet ist/sind.

8. Anordnung nach einem der vorhergehenden Ansprüche, **dadurch gekennzeichnet, dass** die Elektroden (2, 2') die Gestalt äußerer Randbereiche und/oder die Ausrichtung von Rotationsachsen ihnen zugeordneter mikromechanischer Elemente (1) berücksichtigen.

9. Anordnung nach einem der vorhergehenden Ansprüche, **dadurch gekennzeichnet, dass** eine Elektrode (2, 2') zwei benachbarten mikromechanischen Elementen (1), deren Rotationsachsen parallel zueinander ausgerichtet sind, zugeordnet ist.

10. Anordnung nach einem der vorhergehenden Ansprüche, **dadurch gekennzeichnet, dass** eine Elektrode (2, 2') zwei benachbarten mikromechanischen Elementen (1), deren Rotationsachsen nicht parallel zueinander ausgerichtet sind, zugeordnet ist.

11. Anordnung nach einem der vorhergehenden Ansprüche, **dadurch gekennzeichnet, dass** eine Elektrode (2, 2') mindestens drei benachbarten mikromechanischen Elementen (1), deren Rotationsachsen nicht parallel zueinander ausgerichtet sind, zugeordnet ist.

12. Anordnung nach einem der vorhergehenden Ansprüche, **dadurch gekennzeichnet, dass** eine Elektrode (2, 2') mindestens drei benachbarten mikromechanischen Elementen (1), bei denen zwei Rotationsachsen parallel und eine Rotationsachse nicht parallel zueinander ausgerichtet sind, zugeordnet ist.

## Claims

1. An arrangement of micromechanical elements and electrodes which, for electrostatic deflection of the micromechanical elements (1), are arranged therebelow,
- the micromechanical elements (1) in each case being held by means of spring elements and being translationally deflectable or pivotable about at least one axis of rotation by the action of electrostatic force;
- two micromechanical elements (1) which are arranged adjacent to one another being separated by a gap,
- in each case an electrode (2, 2') for electrostatic deflection of at least two micromechanical elements (1) which are arranged adjacent to one another being present in the region of the gaps between adjacent micromechanical elements (1);
**characterised in that** the micromechanical elements (1) are connected to an electric voltage source, and electrodes (2, 2') and/or micromechanical elements (1) can in each case be electrically controlled individually for electrostatic deflection.

2. An arrangement according to Claim 1, **characterised in that** the surface and geometric configuration of the electrode(s) (2, 2') are selected, taking into account the of gap measurements of adjacent micromechanical elements (1) and the aperture of electromagnetic radiation which is incident through gaps (3), such that at least 50% of the incident electromagnetic radiation strikes the surface of electrodes.

3. An arrangement according to Claim 1 or 2, **characterised in that** the one electrode (2, 2') in each case are formed beneath a gap region between micromechanical elements (1) which are arranged adjacent, overlapping the gap region.

4. An arrangement according to one of the preceding claims, **characterised in that** electrodes (2, 2') are formed on that radially outer edge region of micromechanical elements (1) on which the maximum angular deflection in each case strikes.

5. An arrangement according to one of the preceding claims, **characterised in that** a surface, at least in regions, is optically effective for electromagnetic radiation striking the surface.

6. An arrangement according to Claim 5, **characterised in that** the surface reflects electromagnetic radiation.

7. An arrangement according to one of Claims 5 or 6, **characterised in that** one or more of the electrode(s) (2, 2') is/are arranged on the side which is located opposite the side with the optically effective surface.

8. An arrangement according to one of the preceding claims, **characterised in that** the electrodes (2, 2') take into account the shape of outer edge regions and/or the orientation of axes of rotation of micromechanical elements (1) which are associated therewith.

9. An arrangement according to one of the preceding claims, **characterised in that** one electrode (2, 2') is associated with two adjacent micromechanical elements (1), the axes of rotation of which are oriented parallel to one another.

10. An arrangement according to one of the preceding claims, **characterised in that** one electrode (2, 2') is associated with two adjacent micromechanical elements (1), the axes of rotation of which are not oriented parallel to one another.

11. An arrangement according to one of the preceding claims, **characterised in that** one electrode (2, 2') is associated with at least three adjacent micromechanical elements (1), the axes of rotation of which are not oriented parallel to one another.

12. An arrangement according to one of the preceding claims, **characterised in that** one electrode (2, 2') is associated with at least three adjacent micromechanical elements (1), in which two axes of rotation are oriented parallel, and one axis of rotation is not oriented parallel, to one another.

## Revendications

1. Agencement d'éléments micromécaniques et d'électrodes qui, en vue d'une déviation électrostatique d'éléments micromécaniques (1), sont disposées au-dessous de ces dernières,
- les éléments micromécaniques (1) sont maintenus respectivement au moyen d'éléments de ressorts et par l'action d'une force électrostatique pouvant être mis en rotation autour d'au moins un axe de rotation ou pouvant dévier en translation,
- deux éléments micromécaniques (1), disposés de manière adjacente l'un à l'autre, étant séparés par une fente,
- respectivement une électrode (2, 2') étant présente dans la zone des fentes entre des éléments micromécaniques (1) adjacents, en vue d'une déviation électrostatique d'au moins deux éléments micromécaniques (1) disposés de manière adjacente l'un à l'autre,
**caractérisé en ce que** les éléments micromécaniques (1) sont raccordés à une source de tension électrique et des électrodes (2, 2') et/ou des éléments micromécaniques (1) peuvent être activés électriquement, respectivement individuellement, pour une déviation électrostatique.

2. Agencement selon la revendication 1, **caractérisé en ce que** la surface et la forme géométrique de(s) électrode(s) (2, 2') sont choisies en tenant compte des éléments micromécaniques (1) adjacents selon les dimensions des fentes et de l'ouverture du rayonnement électromagnétique incident passant par les fentes (3), de sorte qu'au moins 50 % du rayonnement électromagnétique incident rencontre la surface des électrodes.

3. Agencement selon la revendication 1 ou 2, **caractérisé en ce que** respectivement une électrode (2, 2'), en dessous d'une zone de fente entre des éléments micromécaniques (1) disposés de manière adjacente, est façonnée pour couvrir la zone de fente.

4. Agencement selon l'une quelconque des revendications précédentes, **caractérisé en ce que** des électrodes (2, 2') sont façonnées au niveau d'une zone de bordure radialement extérieure des éléments micromécaniques (1), sur lequel se produit dans chaque cas la plus grande dérivation angulaire.

5. Agencement selon l'une quelconque des revendications précédentes, **caractérisé en ce qu'**une surface est active optiquement, au moins par zones, pour le rayonnement électromagnétique rencontrant la surface.

6. Agencement selon la revendication 5, **caractérisé en ce que** la surface réfléchit le rayonnement électromagnétique.

7. Agencement selon la revendication 5 ou 6, **caractérisé en ce qu'**une ou plusieurs électrode(s) (2, 2') est/sont disposée(s) sur le côté, qui est opposé au côté doté de la surface optiquement active.

8. Agencement selon l'une quelconque des revendications précédentes, **caractérisé en ce que** les électrodes (2, 2') tiennent compte de la forme des zones de bordure extérieures et/ou de l'orientation des axes de rotation des éléments micromécaniques (1) qui leur sont affectés.

9. Agencement selon l'une quelconque des revendications précédentes, **caractérisé en ce qu'**une électrode (2, 2') est affectée à deux éléments micromécaniques (1) adjacents dont les axes de rotation sont orientés parallèlement l'un à l'autre.

10. Agencement selon l'une quelconque des revendications précédentes, **caractérisé en ce qu'**une électrode (2, 2') est affectée à deux éléments micromécaniques (1) adjacents dont les axes de rotation ne sont pas orientés parallèlement l'un à l'autre.

11. Agencement selon l'une quelconque des revendications précédentes, **caractérisé en ce qu'**une électrode (2, 2') est affectée à au moins trois éléments micromécaniques (1) adjacents dont les axes de rotation ne sont pas orientés parallèlement les uns aux autres.

12. Agencement selon l'une quelconque des revendications précédentes, **caractérisé en ce qu'**une électrode (2, 2') est affectée à au moins trois éléments micromécaniques (1) adjacents, parmi lesquels deux axes de rotation sont orientés parallèlement l'un à l'autre et un axe de rotation n'est pas orienté parallèlement à ceux-ci.
